# EUROPÄISCHE PATENTSCHRIFT

(11) **EP 0 795 890 B1**
(45) Veröffentlichungstag und Bekanntmachung des Hinweises auf die Patenterteilung: **29.04.2009**
(21) Anmeldenummer: 97102047.4
(22) Anmeldetag: 10.02.1997
(51) Int. Cl.: H01J 37/34, C23C 16/34, C23C 14/00

(54) **Anordnung zum Beschichten eines Substrats mittels einer Sputter-vorrichtung**
Substrate coating assembly using a sputtering device
Arrangement pour le revêtement de substrats utilisant un dispositif de pulvérisation

(30) Priorität: 14.03.1996 DE 19610012
(43) Veröffentlichungstag der Anmeldung: 17.09.1997
(73) Patentinhaber: Oerlikon Deutschland Holding GmbH, 50968 Köln (DE)
(72) Erfinder: Szczyrbowski, Joachim, Dr. Dipl.-Phys., 63773 Goldbach (DE); Teschner, Götz, Dipl.-Ing., 63450 Hanau (DE); Zmelty, Anton, Dipl.-Ing., 63768 Hösbach (DE); Bruch, Jürgen, Dipl.-Ing., 63546 Hammersbach (DE); Marquardt, Dietmar, 63526 Erlensee (DE)
(74) Vertreter: Schickedanz, Willi

(56) Entgegenhaltungen:
- EP-A- 0 589 699
- DD-A- 282 035
- US-A- 5 292 417

## Beschreibung

Die Erfindung betrifft eine Anordnung nach dem Oberbegriff des Patentanspruchs 1.

Bei der Beschichtung von Substraten, beispielsweise von Glas, mit metallischen Schichten, z. B. mit Aluminium, werden häufig Sputtervorrichtungen eingesetzt, die eine Elektrode mit einem Target aufweisen. Das Target wird aufgrund von auftreffenden elektrisch geladenen Teilchen zerstäubt, wobei sich die zerstäubten Teilchen, gegebenenfalls nach einer Reaktion mit einem Gas, auf dem Substrat niederschlagen. Wird das Target von einem konstanten Magnetfeld durchdrungen, bezeichnet man die Kombination aus Elektrode, Target und Magneten als Magnetron.

Verbinden sich die aus einem Target herausgeschlagenen Metallteilchen vor ihrem Niederschlag auf einem Substrat mit einem Gas, so spricht man von einem reaktiven Sputtern.

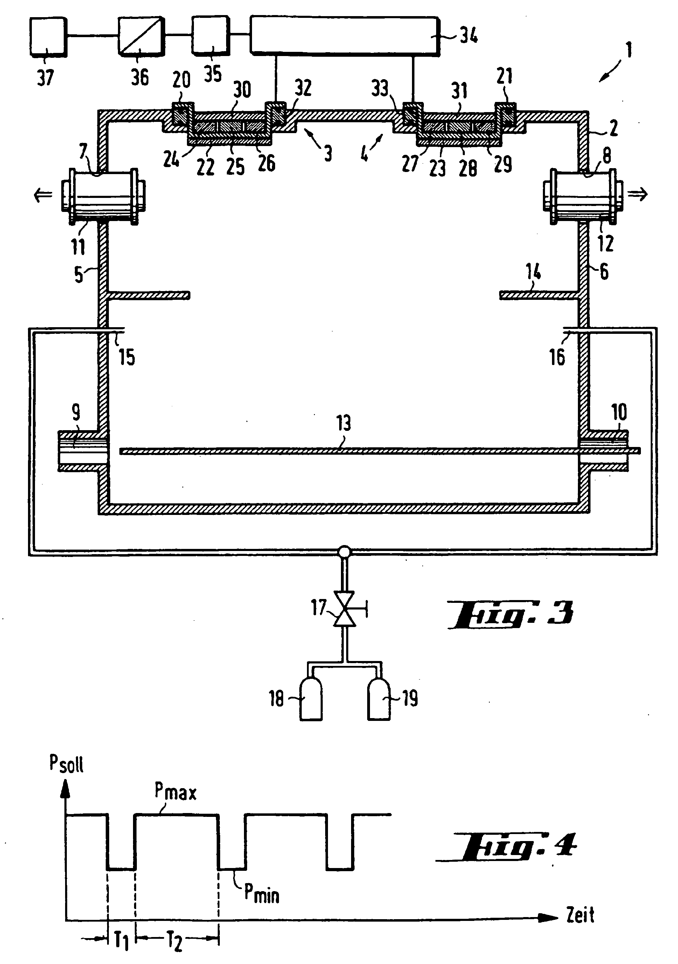

Soll beispielsweise SiO₂ auf ein Substrat aufgedampft werden, werden aus einem Si-Target mittels Ar-Ionen Si-Atome herausgeschlagen, die sich mit Sauerstoff verbinden, der in die Prozeßkammer eingeführt wird. Der eingeführte Sauerstoff beeinflußt bei konstanter elektrischer Leistung die an den Kathoden der Prozeßkammer anstehende Entladespannung. Trägt man die Entladespannung bei konstanter elektrischer Leistung über der O₂-Konzentration auf, dann ergibt sich eine Kurve mit Hysterese (vgl. T. Oyama, H. Ohsaki, Y. Ogata, S. Watanabe, J. Shimizu: "High Rate Deposition of SiO2 Filus by Pulse Sputtering", S. 31 - 36, Fig. 3), Proc. of the 3rd International Symposium on Sputtering & Plasma Processes, June 8 and 9, 1995, Tokyo, Japan). Mit zunehmender Sauerstoffkonzentration fällt die Entladespannung zunächst leicht ab, um dann steil nach unten auf einen niedrigen Wert zu fallen. Von diesem Wert ausgehend nimmt die Entladespannung bei weiterhin zunehmender Sauerstoffkonzentration dann nur noch geringfügig ab. Wird jetzt die Sauerstoffkonzentration reduziert, springt ab einer bestimmten Konzentration die Entladespannung wieder steil nach oben. Da die Sauerstoffkonzentrationen, bei denen die Spannung steil abfällt bzw. steil ansteigt, nicht identisch sind, ergibt sich eine Hysterese.

Durch diese Hysterese wird die Einstellung eines stabilen Arbeitspunkts sehr erschwert, weil schon geringfügige Änderungen der Sauerstoffkonzentration und/oder der zugeführten elektrischen Leistung ein Springen der Entladespannung zur Folge haben können.

Es ist bereits ein Verfahren zum reaktiven Sputtern bekannt, bei welchem das Sputtern und die Beschichtung eines Substrats nur im instabilen Übergangsmode zwischen metallischem und reaktivem Mode erfolgt (US 5 292 417). Hierbei ist der Arbeitspunkt fest eingestellt, und um diesen Arbeitspunkt stabil betreiben zu können, wird der Gleichstrom-Versorgung eine Wechselspannung überlagert, die vorzugsweise im Kilohertz-Frequenzbereich liegt. Eine Verschiebung des Arbeitspunkts soll vermieden werden.

Der Erfindung liegt die Aufgabe zugrunde, den Arbeitspunkt bei reaktivem Sputtern ohne Festhalten des Arbeitspunkts schnell und einfach zu stabilisieren.

Diese Aufgabe wird gemäß den Merkmalen des Patentanspruchs 1 gelöst.

Der mit der Erfindung erzielte Vorteil besteht insbesondere darin, daß eine effektive und schnelle Stabilisierung des Arbeitspunkts ermöglicht wird. Dadurch, daß die Kathode planmäßig abwechselnd zwischen dem metallischen Mode und dem oxidischen Mode betrieben wird, bildet sich ein Mittelwert zwischen den Moden, so daß die Kathode scheinbar auf den metallischen Zwischenzuständen zwischen metallisch und oxidisch stabilisiert werden kann. Bei der Herstellung von Stoffen wie TiO₂ ist dies ein Weg, um trotz fehlender elektrischer Signale, die von dem Sputterprozeß abgeleitet sind, einen Hochratenarbeitspunkt stabilisieren zu können.

Ausführungsbeispiele der Erfindung sind in den Zeichnungen dargestellt und werden im folgenden näher beschrieben. Es zeigen:
- Fig. 1: Spannungs-Sauerstoff-Kennlinien eines NiCr-Sputtervorgangs bei zwei verschiedenen elektrischen Sputterleistungen;
- Fig. 2: eine Spannungs-Sauerstoff-Kennlinie eines Ti-Sputtervorgangs bei konstanter elektrischer Leistung;
- Fig. 3: eine Sputteranlagen mit zwei Magnetrons und einer Mittelfrequenzstromversorgung;
- Fig. 4: eine Darstellung des Leistungssollwertes über der Zeit;
- Fig. 5: eine Mittelfrequenzstromversorgung und eine Wechselspannungsquelle mit zwischengeschalteter Mittelfrequenz-Siebschaltung;
- Fig. 6: die Ausgangsspannung der Wechselspannungsquelle über der Zeit;
- Fig. 7: eine Schalteranordnung zwischen einer Gleichstromversorgung und Sputterkathoden;
- Fig. 8: der durch eine Kathode einer Doppelkathodenanordnung fließende Strom über der Zeit.

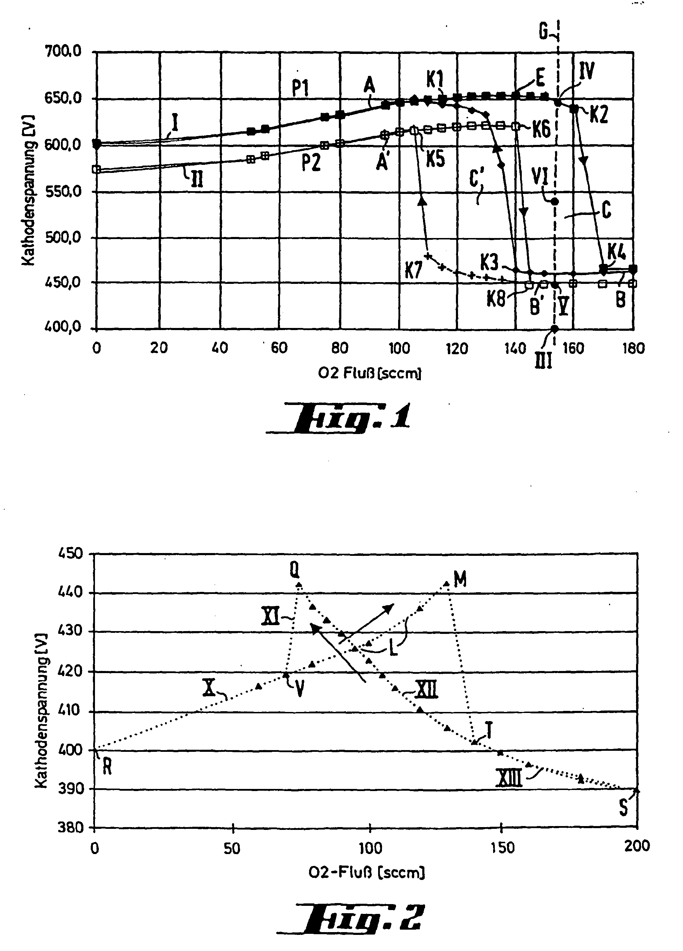

In der Fig. 1 sind zwei Spannungs-Sauerstoff-Kennlinien eines NiCr-Sputtervorgangs bei zwei verschiedenen elektrischen Sputterleistungen P1 und P2 dargestellt. Diese NiCr-Kennlinien stehen stellvertretend für zahlreiche andere Metall-Kennlinien, die sich ergeben, wenn Metall-Targets oder Metall-Legierung-Targets gesputtert werden.

Die obere Kennlinie I ergibt sich bei einer konstant eingestellten elektrischen Leistung P1, während sich die untere Kennlinie II bei einer konstant eingestellten elektrischen Leistung P2 ergibt. P1 ist hierbei größer als P2. Die Spannungen sind in Volt und der Sauerstofffluß ist in sccm = standard cubiccentimeter pro minute angegeben.

Die Kennlinien I, II sind deutlich in drei Bereiche unterteilt: einen oberen Bereich A bzw. A', einen unteren Bereich B bzw. B' und einen Zwischenbereich C bzw. C'. Der Zwischenbereich C bzw. C' kennzeichnet hierbei die Hysterese.

Die Bereiche B, B' werden als oxidischer Mode bezeichnet, während die Bereiche A, A' als metallischer Mode bezeichnet werden.

Im metallischen Mode A, A' weist das Target, das gesputtert wird, noch eine metallische Oberfläche auf, während es im oxidischen Mode B, B' stark mit Sauerstoff angereichert ist.

Die Sputterraten sind im metallischen Mode groß und im oxidischen Mode klein. Man ist deshalb bestrebt, den Sputtervorgang möglichst im metallischen Mode zu halten und ein Abgleiten in den oxidischen Mode zu vermeiden. Zu einem solchen Abgleiten kann es kommen, wenn infolge von Fluktuationen im Prozeß der Sauerstofffluß zeitweilig über den Wert des Punktes K2 bzw. K6 in Fig. 1 hinausgeht.

Wie man aus der Fig. 1 erkennt, verlagern sich bei geänderten Leistungen auch die Hysterese oder Zwischenbereiche C, C'.

Mit diesen Bereichen verlagern sich die Kipp-Punkte K1, K2, K3, K4 bzw. K5, K6, K7, K8 der Kurven I bzw. II. Wird die elektrische Leistung z. B. von P1 auf P2 erhöht, wird mehr Sauerstoff benötigt, um die gleiche Sauerstoffsättigung des Targets zu erhalten wie zuvor. Damit verschieben sich die Kipp-Punkte K5 - K8 der Kennlinie II zu den Kipp-Punkten K1 - K4 der Kennlinie II, denen höhere Sauerstoffflüsse zugeordnet sind.

Befindet sich die Kathode im metallischen Mode A und wird die elektrische Leistung von P1 auf P2 verkleinert, entsteht bei gleichbleibender Sauerstoffzufuhr ein größerer Sauerstoffüberschuß. Weil infolge der verringerten Leistung weniger Material abgestäubt wird, wird auch weniger Sauerstoff verbraucht, so daß der Sauerstoffanteil im Sputtergas und damit auch in der Targetoberfläche ansteigt. Wird ein spezifischer Punkt im Sauerstoffanteil in der Targetoberfläche überschritten, so ruht die Sputterrate weiter und damit steigt der Sauerstoffgehalt im Sputtergas. Es findet eine Selbstverstärkung statt. Wird z. B. eine Sputteranlage bei der Leistung P1 mit einem Sauerstoffzufluß von 140 sccm betrieben, so ergibt sich ein relativ stabiler Arbeitspunkt E auf der Kennlinie I. Wird jetzt die Leistung auf P2 reduziert, springt der Arbeitspunkt zum Punkt K6 der Kennlinie II und stürzt damit zum Punkt K8 ab. Dieser Prozeß wird das Kippen der Kathode in den oxidischen Mode genannt, z. B. im Punkt K6. Er ist damit ein selbstverstärkender Prozeß. Wenn auf der Kennlinie I in einem Bereich gearbeitet wird, bei dem eine Kurve II einen Kipp-Punkt K6 besitzt, reichen somit Leistungsschwankungen bis zu P2 eines Stromgenerators aus, um ein Kippen zu erzeugen.

Aus technologischer Sicht ist der Bereich C bzw. C' sehr interessant. Es ergeben sich sehr gute Schichteigenschaften bei hoher Beschichtungsrate. Deshalb wird angestrebt, in diesem Bereich zu arbeiten.

Um in diesem Bereich das Kippen zu vermeiden, wird erfindungsgemäß zwischen der ersten Leistung P1 und der zweiten Leistung P2 hin- und hergeschaltet, und zwar bei konstantem Reaktivgasfluß. Damit wird in der Kathodenoberfläche ein Sauerstoffanteil stabilisiert, der einem virtuellen Arbeitspunkt im Hysteresisbereich C bzw. C' entspricht.

Liegt ein konstanter Reaktivgasfluß beispielsweise im Punkt III, also bei etwa 152 sccm, so stellt sich bei einer Leistung P1 der Arbeitspunkt IV ein, d. h. es liegt eine Entladespannung von ca. 650 Volt an der Kathode.

Wird nun bei gleichem Reaktivgasfluß gezielt auf die Leistung P2 umgeschaltet, stellt sich der Arbeitspunkt V auf der Kennlinie II ein.

Wird fortwährend zwischen P1 und P2 umgeschaltet, ergibt sich der virtuelle Arbeitspunkt VI, der zwischen IV und V und damit zwischen den beiden Modi liegt. Die Schnittgerade G, die in der Fig. 1 durch die Punkte IV, VI, V und III geht, soll sich zwischen den Punkten K1 - K8 befinden. Ginge die Schnittgerade G beispielsweise durch den Punkt K6, würde sich beim Umschalten von P1 auf P2 kein eindeutiges Ergebnis zeigen, weil die Kurve II bei 140 sccm zwei Schnittpunkte mit der Schnittgeraden G hätte, d. h. es wäre ungewiß, ob sich der Arbeitspunkt bei der Leistung P2 bei K6 oder in der Nähe von K8 einstellen würde. Der Abstand der Geraden G vom Punkt K2 in Fig. 1 ist relativ gering und sollte in der Praxis etwas größer gewählt werden.

Würde andererseits die Gerade G nach rechts parallelverschoben und durch den Punkt K2 gelegt, läge zwar der Schnittpunkt mit der Kurve II im oxidischen Bereich relativ eindeutig fest, doch würde beim Umschalten auf die Leistung P1 leicht ein instabiler Bereich der Kurve I getroffen werden, so daß der Arbeitspunkt wahrscheinlich im oxidischen Mode bleibt.

Zur Durchführung des erfindungsgemäßen Verfahrens geht man zweckmäßigerweise wie folgt vor.

Es werden wenigstens zwei Kennlinien I, II aufgenommen, wie sie in der Fig. 1 dargestellt sind. Sind diese Kennlinien bekannt, wird zunächst die niedrigere Leistung P2 eingestellt und solange Sauerstoff zugeführt, bis die Spannung im Punkt K6 nach unten zum Punkt K8 kippt. Jetzt wird noch ein wenig mehr Sauerstoff zugeführt, damit die Gerade G einen Abstand rechts vom Kipp-Punkt K8 hat. Dieser Abstand wird durch den Punkt V definiert. Bei dem nun eingestellten Sauerstofffluß wird jetzt auf die höhere Leistung P1 umgeschaltet und festgestellt, ob die Kathodenspannung nach oben springt und dann etwa konstant bleibt. Ist dies der Fall, wird der Sauerstoffzufluß fixiert. Ist die Spannung instabil, wird der Gasfluß geändert, weil in diesem Fall der zweite Schnittpunkt der Geraden G auf einem Hystereseast liegt. Die Änderung des Gasflusses erfolgt so lange, bis sich eine stabile Spannung ergibt.

In der Fig. 2 ist eine weitere Spannungs-Sauerstoff-Kennlinie dargestellt, die jedoch für ein Titan-Target gilt. Diese Kennlinie bezieht sich nur auf eine elektrische Sputterleistung und soll lediglich zeigen, daß die Spannungs-Sauerstoff-Kennlinien stark materialabhängig sind. Wird die Sauerstoffzufuhr von Null ausgehend allmählich erhöht, so steigt bei konstanter elektrischer Leistung die Spannung im Bereich X linear an, um dann im Punkt M abrupt zum Punkt T abzufallen. Bei weiterer Zunahme des Sauerstoffzuflusses klingt die Spannung im Bereich XIII parabelförmig aus, um im Punkt S einen niedrigsten Wert einzunehmen.

Wird jetzt die Sauerstoffzufuhr wieder zurückgeführt, so verläuft die Spannung in einem Bereich XIII zunächst exakt umgekehrt wie bei der Sauerstoffzunahme. Von einem Punkt T an steigt jedoch die Spannung bis zu einem Punkt Q, um bei weiterer Sauerstoffreduzierung abrupt zum Punkt V abzufallen und die gleiche Kennlinie im Bereich X wie bei Sauerstoffzunahme zu erreichen.

Eine zweite, in der Fig. 2 nicht dargestellte Kennlinie, die bei einer anderen eingestellten Leistung aufgenommen wird, hätte eine ähnliche Kurvenform, jedoch mit einem Versatz zur Seite und nach oben. Die beiden Punkte, zwischen denen hin- und hergeschaltet wurde, müßten einen sicheren Abstand von den Punkten V, Q, M und T haben bzw. von den korrespondierenden Punkten der nicht dargestellten zweiten Kennlinie.

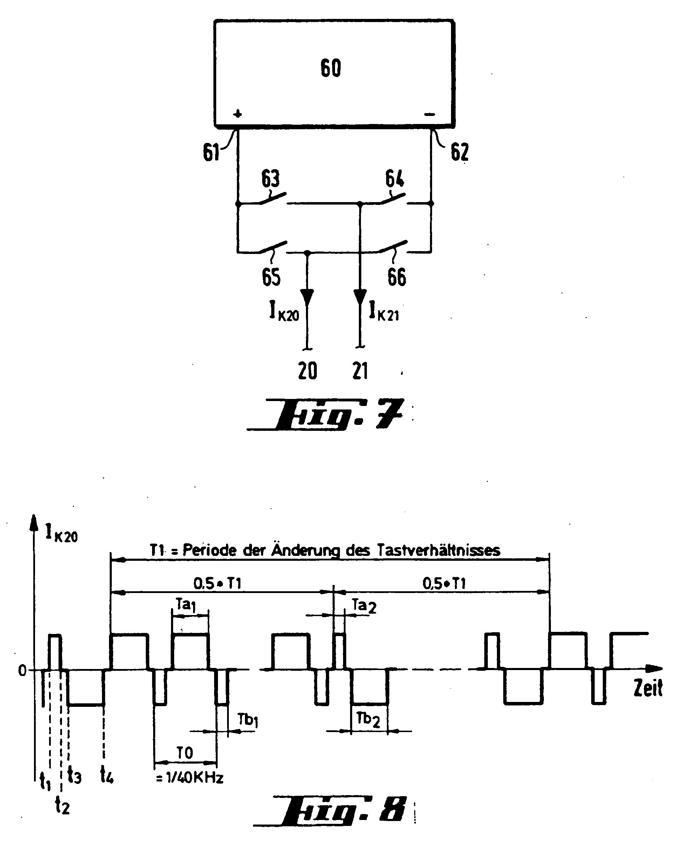

Der in der Fig. 1 dargestellte virtuelle Arbeitspunkt VI kann durch geeignete Wahl eines Tastverhältnisses zwischen P1 und P2 auf der Geraden G nach oben oder unten verschoben werden. Wie dies im einzelnen geschieht, wird weiter unten im Zusammenhang mit den Fig. 4 und 8 erläutert.

In der Fig. 3 ist eine Sputteranlage 1 dargestellt, mit der die Erfindung realisiert werden kann. Sie weist eine Vakuumkammer 2 auf, in der sich zwei Magnetrons 3, 4 befinden. In Seitenwänden 5, 6 der Vakuumkammer 2 sind obere Öffnungen 7, 8 und untere Öffnungen 9, 10 vorgesehen, wobei sich in den oberen Öffnungen Vakuumpumpen 11, 12 befinden, während die unteren Öffnungen 9, 10 zur Durchschleusung eines Substrats 13, beispielsweise einer Glasplatte, durch die Vakuumkammer 2 dienen. Zwischen den unteren Öffnungen 9, 10 und den oberen Öffnungen 7, 8 befindet sich eine Blende 14, die von den Seitenwänden 5, 6 in das Innere der Vakuumkammer 2 ragt. Unterhalb dieser Blende 14 befinden sich Gaszuführungen 15, 16, die über ein Ventil 17 mit Gasbehältern 18, 19 in Verbindung stehen.

Die Magnetrons 3, 4 weisen jeweils eine Kathodenwanne 20, 21 auf, die auf ihrer Unterseite mit einem Target 22, 23 versehen ist. In der Kathodenwanne 20, 21 befinden sich jeweils drei Dauermagnete 24, 25, 26 bzw. 27, 28, 29, die mit einem gemeinsamen Joch 30, 31 verbunden sind. Die Kathodenwannen 20, 21 sind über Dichtungen 32, 33 in die Oberseite der Vakuumkammer 2 eingepaßt. Beiden Kathodenwannen 20, 21 sind mit einer Mittelfrequenz-Stromversorgung 34 verbunden, die ihrerseits mit einem Leistungsregler 35 verbunden ist, der über einen Digital-Analog-Wandler 36 von einem Rechner 37 gesteuert wird.

Die beiden Magnetrons 3, 4 der Sputteranlage 1 sind in der Fig. 3 dicht nebeneinander und in der gleichen Kammer 2 angeordnet. Es können jedoch auch zwei getrennte Abteilungen in der Kammer 2 vorgesehen sein, von denen jede ein eigenes Magnetron aufweist. Die Gaseinlässe 15 bis 19 sind so ausgelegt, daß den beiden Magnetrons 3, 4 die gleiche Reaktivgaszusammensetzung zugeführt wird.

Die elektrische Leistung, die den Kathoden 20, 21 zugeführt wird, wird über den Mittelfrequenzgenerator 34 moduliert.

Eine solche Leistungsmodulation ist in der Sputtertechnik an sich bekannt (vgl. EP-A-0 347 567, DE-C-3 700 633). Hierbei pendelt zwar die Leistung zwischen zwei Werten, doch ist mit diesem Pendeln weder eine stabile Arbeitspunkteinstellung beabsichtigt noch möglich. Entsprechendes gilt auch für andere bekannte Anordnungen, bei denen an der Kathode eine Polaritätsumkehr und damit eine Leistungsänderung herbeigeführt wird (EP-A-0 591 675; DE-A-42 37 517, Fig. 1, 2; DE-A-43 43 042, Sp. 4, Zeilen 48 bis 62). Bei den bekannten Leistungsmodulationen ist die Änderung der Leistung in der Regel eine Folge einer gewollten Spannungsänderung, d. h. an der Änderung der elektrischen Leistung besteht kein grundsätzliches Interesse.

Die Fig. 4 zeigt, wie eine erfindungsgemäße Leistungsmodulation aussieht. Man erkennt hierbei, daß die Amplitude der Soll-Leistung P_{Soll} periodisch etwa um den Faktor 2 geändert wird, wobei die höhere Leistung Pₘₐₓ etwa dreimal so lang ansteht wie die niedrigere Leistung Pₘᵢₙ, d. h. das Tastverhältnis T₂/T₁ ist etwa drei. Die mit Pₘₐₓ bzw. Pₘᵢₙ bezeichneten Leistungen entsprechen hierbei den Leistungen P1 und P2 gemäß Fig. 1. Sie werden nach bestimmten Kriterien ausgewählt. Die Darstellung der Fig. 4 zeigt nur die Einhüllende bzw. den Mittelwert der Leistung. In Wirklichkeit liegen in jedem Puls etwa viertausend Halbwellen der Mittelfrequenzleistung bei einer typischen Modulationsfrequenz von 10 Hz und einer Mittelfrequenz von 40 kHz.

Schaltungstechnisch läßt sich der Leistungsverlauf in der Weise realisieren, daß ein Rechner jeweils zu Beginn und am Ende einer Zeit T₁, T₂ einen digitalen Befehl auf den Digital-Analog-Wandler 36 gibt, der diesen in ein Analog-Signal umwandelt und mit diesem den Leistungsregler 35 beaufschlagt, der die an die Kathoden 20, 21 abgegebene Leistung steuert. Der vom Rechner bestimmte Sollwert wird mit einer Zyklusfrequenz 1/(T₁ + T₂) von etwa 10 Hz zwischen einem hohen und einem niedrigen Sollwert umgeschaltet. Die 10 Hz sind hierbei vorgegeben. Die Frequenz ist so auszuwählen, daß die Kathode in dem Übergangsbereich stabil brennt. Wird die Frequenz zu niedrig, wandert die Kathode zu weit in den jeweiligen Mode und kann unkontrollierbar in einen von diesen Moden kippen. Bei zu hoher Frequenz verschwindet der Stabilisierungseffekt des Arbeitspunktes.

Die beiden Werte Pₘₐₓ und Pₘᵢₙ (bzw. P1 und P2 in Fig. 1) sind dabei so gewählt, daß der hohe Leistungssollwert Pₘₐₓ bei dem gegebenen Sauerstofffluß einen Arbeitspunkt im metallischen Mode bzw. der niedrige Leistungssollwert Pₘᵢₙ einen Arbeitspunkt im oxidischen Mode zur Folge hätten, wenn nicht umgeschaltet würde. Dadurch, daß die Leistung periodisch geändert wird, bleiben die Kathoden in den Übergangszuständen zwischen den beiden Modi. Durch die Änderung der Generatorspannung wird automatisch auch die Plasmaimpedanz geändert. Geregelt wird deshalb die Spannungsänderung.

Anders ausgedrückt: Technisch wird die Leistung durch eine Änderung der den Elektroden zugeführten elektrischen Gleichspannung geregelt, weil eine Spannungsänderung eine Änderung der Plasmaimpedanz zur Folge hat, was wiederum zu veränderten Stromflüssen führt. Der fließende Strom und die anliegende Spannung bestimmen jedoch die elektrische Leistung.

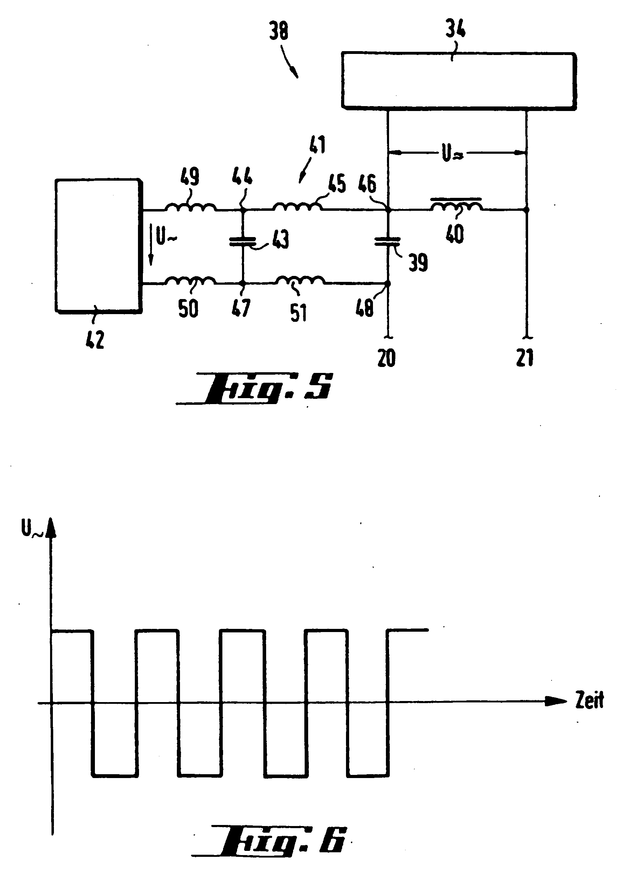

In der Fig. 5 ist eine Schaltungsanordnung 38 gezeigt, mit der verschiedene Leistungen auf die Kathoden gegeben werden können. Die Modulation der Leistung in den Kathoden 20, 21 wird hierbei nicht durch die Ansteuerung des Mittelfrequenzgenerators 34 erzeugt, sondern es ist zwischen dem Mittelfrequenzgenerator 34 und den Kathoden 20, 21 ein Netzwerk eingefügt, das aus einem Kondensator 39, einer Gleichstromdrossel 40, einem Filter 41 und einer Wechselspannungsquelle 42 besteht, welche die gleiche Frequenz wie die Wechselspannungsquelle 35 hat, nämlich ca. 10 Hz. Das Filter 41 weist hierbei z. B. einen Kondensator 43 auf, der mit seinem einen Anschluß 44 über eine erste Induktivität 45 mit dem einen Anschluß 46 des Kondensators 39 und mit seinem anderen Anschluß 47 über eine zweite Induktivität 51 mit dem anderen Anschluß 48 des Kondensators 39 verbunden ist. Außerdem sind seine Anschlüsse 44 bzw. 47 über jeweils eine Induktivität 49, 50 mit der Wechselspannungsquelle verbunden. Die Mittelfrequenzenergie wird über den Kondensator 39 in die Kathoden 20, 21 eingespeist. Zu der Leistungsmodulation kommt es, weil der Leistung aus dem Mittelfrequenzgenerator 34 am Kondensator 39 eine zusätzliche Wechselspannungsleistung aus der Wechselspannungsquelle 42 überlagert wird. Hierdurch werden die Strom-Spannungskennlinien der Kathoden 20, 21 verschoben. Als Ergebnis dieser Verschiebung ergibt sich, daß die Kathoden 20, 21 mit unterschiedlicher Leistung arbeiten. Bei dem Filter 41 handelt es sich um ein Mittelfrequenzfilter, das verhindert, daß elektrische Leistung vom Mittelfrequenzgenerator 34 zur Wechselstromquelle 42 fließt. Es soll eine hohe Impedanz für die Mittelfrequenzquelle 34 und eine niedrige Impedanz für die Wechselstromquelle 42 darstellen.

Die zusätzliche Wechselspannung der Wechselspannungsquelle 42 wird so gewählt, daß die eine Kathode 20, wenn an ihr die negative Halbwelle der Wechselspannung liegt, so viel Leistung aufnimmt, daß sie bei vergleichbarem Betrieb mit konstanter Mittelfrequenzleistung im metallischen Mode arbeiten würde. Die andere Kathode 21 nimmt zur gleichen Zeit weniger Leistung auf, so daß sie bei vergleichbarem Betrieb mit konstanter Mittelfrequenzleistung im oxidischen Mode arbeiten würde. Auf diese Weise wird ein ähnlicher Effekt erreicht wie mit der Modulation der Mittelfrequenzleistung, mit dem Unterschied, daß im Fall der Fig. 3 die beiden Kathoden 20, 21 im gleichen Mode sputtern, während im Fall der Fig. 5 jeweils eine Kathode 20 oder 21 im metallischen und eine Kathode 21 oder 20 im oxidischen Mode arbeitet. Unter Mittelfrequenz wird hierbei eine Frequenz im Bereich von einigen kHz bis ca. 100 kHz verstanden. Eine bevorzugte Mittelfrequenz hat z. B. 40 kHz.

Die Frequenz der Wechselspannungsquelle 42 ist die gleiche wie die der Wechselspannungsquelle 35 in Fig. 3, d. h. ca. 10 Hz. In der Fig. 6 ist dargestellt, wie diese Wechselspannung U_{∼} verläuft. Die Wechselspannung kann sowohl rechteck- als auch sinusförmig sein.

Die Leistung, die einer oder zwei Kathoden zugeführt wird, kann auch aus einer Gleichstromquelle stammen, der ein Wechselstrom überlagert ist. Derartige aus Gleich- und Wechselstromquellen bestehende Leistungsquellen sind im Prinzip bekannt (vgl. F. Vratny, Deposition and Tantalum and Tantalum Oxide by superimposed RF and DC-Sputtering, J. Electrochem. Soc.: Solid State Science, May 1967, S. 506, Fig. 1) und brauchen deshalb nicht näher dargestellt zu werden. Die erfindungsgemäß verwendete Wechselstromfrequenz liegt allerdings zwischen etwa 1 und 30 Hz und ist damit erheblich niedriger als bei der bekannten Schaltungsanordnung, wo sie im MHz-Bereich liegt.

In der Fig. 7 ist eine weitere Anordnung dargestellt, mit der es möglich ist, die den Kathoden zugeführten Leistungen zu variieren. Hierbei ist eine Gleichstromversorgung 60 vorgesehen, die eine Konstantstromquelle ist. Parallel zu den Ausgangsanschlüssen 61, 62 der Gleichstromversorgung liegen zwei erste steuerbare Schalter 63, 64 in Reihe, zu denen zwei weitere in Reihe geschaltete steuerbare Schalter 65, 66 parallelgeschaltet sind.

Der konstante Gleichstrom der Stromversorgung 60 wird durch die steuerbaren Schalter 63 bis 66 wechselseitig den Kathoden 20, 21 zugeführt. Zwischen den Phasen, in denen die Kathoden 20, 21 Strom führen, liegt ein Umschaltzeitpunkt, in dem der Umschalter 63 bis 66 die Gleichstromversorgung 60 kurzschließt, so daß kein Strom zu den Kathoden 20, 21 fließen kann. Dieser Kurzschluß kann durch gleichzeitiges Schließen der Schalter 63, 64 oder der Schalter 65, 66 oder der Schalter 63 bis 66 erfolgen.

Der Umschalter 63 bis 66 wird unsymmetrisch gesteuert, so daß die Brennzeiten und damit der Leistungsbeiträge der beiden Kathoden 20, 21 innerhalb eines vorgegebenen Zeitraums unterschiedlich sind. Dadurch kann erreicht werden, daß eine Kathode 20 im metallischen und die andere Kathode 21 im oxidischen Mode sputtert. Wechselt man diese Unsymmetrie periodisch, so wird der gleiche Effekt erreicht wie mit der Modulation der Mittelfrequenzleistung mittels einer zusätzlichen Wechselspannung gemäß Fig. 5.

Eine weitere Möglichkeit der Leistungszuführung besteht darin, in der Anordnung gemäß Fig. 5 die Wechselspannungsquelle 42 und das Filter 41 wegzulassen und anstelle der Drossel 40 ein spezielles Filter einzusetzen. Dieses Filter wird dann so dimensioniert, daß es eine Resonanzfrequenz f₁ hat, die in der Nähe der Frequenz fₒ des Mittelfrequenzgenerators 34 liegt. Handelt es sich bei dem Mittelfrequenzgenerator 34 um einen freischwingenden Generator, dessen Frequenz nicht stabilisiert ist, kommt es zu Schwebungen, die einen Modulationseffekt bewirken.

In der Fig. 8 ist ein Strom-Zeit-Diagramm zur Anordnung der Fig. 7 dargestellt. Hierbei ist gezeigt, wie der Strom I_{K20} durch die Kathode 20 in Abhängigkeit von der Zeit fließt. Der durch die Kathode 21 fließende Strom ist hierbei nicht dargestellt. Er ist jedoch mit dem durch die Kathode 20 fließenden Strom, mit Ausnahme einer Phasenverschiebung, identisch. Im Zeitpunkt t₁ wird bei geöffneten Schaltern 63, 64 der Schalter 65 geschlossen, so daß ein positiver Strom I_{K20} von der Stromversorgung 60 zur Kathode 20 fließt.

Zum Zeitpunkt t₂ wird der Schalter 65 wieder geöffnet, d. h. es fließt kein Strom mehr vom positiven Anschluß der Stromversorgung 60 zur Kathode 20. Zum Zeitpunkt t₃ wird der Schalter 66 geschlossen, so daß der Strom I_{K20} vom negativen Anschluß der Stromversorgung 60 zur Kathode 20 fließt. Wird der Schalter 66 zum Zeitpunkt t₄ geöffnet, kann kein negativer Strom mehr zur Kathode 20 fließen.

Das Öffnen und Schließen der Schalter 65, 66 wird nun in der Weise fortgesetzt, daß sich der in der Fig. 8 gezeigte Stromverlauf ergibt. Die Kathode 20 wird also zunächst für eine relativ kurze Zeit t₂ - t₁ mit positivem Strom beaufschlagt, während sie dann für einen etwas längeren Zeitraum t₄ - t₃ mit negativem Strom beaufschlagt wird. Anschließend wird sie für den längeren Zeitraum |t₄ - t₃| mit positivem Strom beaufschlagt, hierauf für den kürzeren Zeitraum |t₂ - t₁| mit negativem Strom, anschließend wieder für den längeren Zeitraum |t₄ - t₃| = Tₐ₁ mit positivem Strom und anschließend wieder für die kürzere Zeit |t₂ - t₁| = T_{b1} mit negativem Strom.

Die Indizes a und b bei T beziehen sich auf die Zeitdauer des positiven und negativen Stromwertes der Kathode 20 in einer Periode T₀ der Mittelfrequenzquelle. Die zusätzliche Modulation hat die Periode T₁. In der ersten Hälfte der Periode T₁ ist die gesamte Zeitdauer des positiven Stroms in der Kathode 20 länger als die Zeitdauer des negativen Stroms. In der zweiten Hälfte wird die gesamte Zeitdauer des negativen Stroms länger als die des positiven Stroms.

Der längere Zeitraum Tₐ₁ und der kürzere Zeitraum T_{b1} bilden zusammen den Zeitraum T₀, d. h. die Periodendauer der durch das Umschalten der Gleichstromquelle 60 entstandenen Mittelfrequenzspannung. Diese Periodendauer beträgt beispielsweise 25 µs oder 1/40 kHz.

Auf entsprechende Weise wie die Kathode 20 wird auch die Kathode 21 mit Strom versorgt, wobei jedoch die Schalter 63 und 64 anstelle der Schalter 65 und 66 geöffnet bzw. geschlossen werden.

## Patentansprüche

1. Zerstäubungsvorrichtung zum Ätzen oder Beschichten eines Substrats mit Metallverbindungen, die durch Zerstäuben eines metallischen Targets und Verbindung der so entstandenen Targetpartikel mit einem Reaktivgas gewonnen werden, mit
1.1 einem Prozessraum (2);
1.2 einer Reaktivgaszuführung (15, 16) in den Prozessraum (2);
1.3 wenigstens einer Elektrode (20, 21), die mit einer elektrischen Energieversorgung (34) verbindbar ist, wobei die Entladespannung der Elektrode (20, 21) von der pro Zeiteinheit zugeführten Menge des Reaktivgases abhängt;
1.4 einer Einrichtung, die dazu eingerichtet ist, die der Elektrode (20, 21) zugeführte elektrische Leistung zwischen einem ersten und einem zweiten Wert periodisch umzuschalten;
**dadurch gekennzeichnet, dass** der erste und der zweite Leistungswert (P1, P2) so ausgewählt sind, dass sich bei gleichem Reaktivgaszufluss das Target (22, 23) beim ersten Leistungswert (P1) im metallischen Mode (A) befindet, während es sich beim zweiten Leistungswert (P2) im oxidischen Mode (B') befindet.

2. Zerstäubungsvorrichtung nach Anspruch 1, mit zwei Elektroden (20, 21), wobei die Einrichtung zum periodischen Umschalten von der ersten zugeführten elektrischen Leistung (P1) auf die zweite elektrische Leistung (P2) dazu eingerichtet ist, beide Elektroden mit jeweils der gleichen Leistung (P1 oder P2) zu beaufschlagen.

3. Zerstäubungsvorrichtung nach Anspruch 1, mit zwei Elektroden (20, 21), wobei die Einrichtung zum periodischen Umschalten von der ersten zugeführten elektrischen Leistung (P1) auf die zweite elektrische Leistung (P2) dazu eingerichtet ist, die erste Elektrode (20) mit einer ersten Leistung (P1) zu beaufschlagen und gleichzeitig die zweite (21) mit einer zweiten Leistung (P2) zu beaufschlagen, und in einem hieran anschließenden Zeitraum die erste Elektrode (20) mit der zweiten Leistung (P2) und die zweite Elektrode (21) mit der ersten Leistung (P1) zu beaufschlagen.

4. Zerstäubungsvorrichtung nach Anspruch 1, **dadurch gekennzeichnet, dass** die Einrichtung zum periodischen Umschalten von der ersten zugeführten elektrischen Leistung (P1) auf die zweite elektrische Leistung (P2) eine modulierte Wechselspannungsquelle (34) ist.

5. Zerstäubungsvorrichtung nach Anspruch 1, **dadurch gekennzeichnet, dass** die Einrichtung zum periodischen Umschalten von der ersten zugeführten elektrischen Leistung (P1) auf die zweite zugeführte elektrische Leistung (P2) eine Gleichstromquelle und eine Wechselstromquelle beinhaltet, wobei Gleichstrom und Wechselstrom überlagert sind.

6. Zerstäubungsvorrichtung nach Anspruch 1, **dadurch gekennzeichnet, dass** die Einrichtung zum periodischen Umschalten von einer ersten zugeführten Leistung (P1) auf die zweite zugeführte elektrische Leistung (P2) eine Gleichstromquelle (60) ist, deren Ausgänge mittels Schaltern (63 bis 66) umschaltbar sind.

7. Zerstäubungsvorrichtung nach Anspruch 5, **dadurch gekennzeichnet, dass** die überlagerte Wechselspannung eine Frequenz zwischen 2 bis 30 Hz aufweist.

8. Zerstäubungsvorrichtung nach Anspruch 1, **dadurch gekennzeichnet, dass** die Umschaltung vom metallischen Mode zum oxidischen Mode und umgekehrt mit einer Zyklusfrequenz von 10 Hz erfolgt.

9. Zerstäubungsvorrichtung nach Anspruch 1, **dadurch gekennzeichnet, dass** die Einrichtung, mit welcher die der Elektrode zugeführte elektrische Leistung zwischen einem ersten und einem zweiten Wert umschaltbar ist, eine Wechselspannungsquelle (34) enthält, die durch eine weitere Wechselspannungsquelle (42) moduliert wird.

10. Zerstäubungsvorrichtung nach Anspruch 9, **dadurch gekennzeichnet, dass** sie ein Netzwerk und einen Kondensator enthält, wobei die Wechselspannungsquelle (42) über das Netzwerk (41) mit dem Ausgang der ersten Wechselspannungsquelle (34) verbunden ist, wobei dieses Netzwerk (41) an dem Kondensator (39) liegt, der in einer Ausgangsleitung der Wechselspannungsquelle (34) angeordnet ist.

11. Zerstäubungsvorrichtung nach Anspruch 1, mit einem Target (22, 23), Dauermagneten (24 - 29), einem Gehäuse (2) und einer Blende (14), wobei die Elektrode (20, 21) zusammen mit dem Target (22, 23) und den Dauermagneten (24 - 26; 27 - 29) ein Magnetron (3, 4) bildet, wobei sich dieses Magnetron (3, 4) innerhalb des zu evakuierenden Gehäuses (2) befindet und gegenüber dem Substrat (13) angeordnet ist und wobei das Gehäuse (2) zwischen Substrat (13) und Magnetron (3, 4) die Blende (14) aufweist.

12. Zerstäubungsvorrichtung nach Anspruch 11, mit einer Einrichtung zur Einführung eines reaktiven Gasgemisches in das Gehäuse (2), wobei das Gasgemisch zwischen dem Substrat (13) und der Blende (14) eingeführt wird.

13. Zerstäubungsvorrichtung nach Anspruch 1, mit einer elektrischen Energiequelle, wobei die elektrische Energiequelle einen Mittelfrequenzgenerator (34) mit einer Frequenz f₀ und ein Netzwerk mit einer Resonanzfrequenz f₁ aufweist, wobei f₀ und f₁ derart dicht beieinander liegen, dass sich eine Schwebung ergibt, welche die Leistung der Zerstäubungsvorrichtung moduliert.

14. Verfahren zum Einstellen eines Arbeitspunkts einer Zerstäubungsvorrichtung nach Anspruch 1, **gekennzeichnet durch** folgende Schritte:
a) es wird eine erste Entladespannungs-Reaktivgaszuführungs-Kennlinie (I) bei einer ersten elektrischen Leistung (P1) ermittelt;
b) es wird eine zweite Entladespannungs-Reaktivgaszuführungs-Kennlinie (II) bei einer zweiten elektrischen Leistung (P2) ermittelt;
c) es wird auf der ersten Entladespannungs-Reaktivgaszuführungs-Kennlinie (I) ein Arbeitspunkt (IV) ermittelt, bei dem die Zerstäubungsvorrichtung im metallischen Mode arbeitet;
d) es wird auf der zweiten Entladespannungs-Reaktivgaszuführungs-Kennlinie (II) ein Arbeitspunkt (B') ermittelt, bei dem die Zerstäubungsvorrichtung im oxidischen Mode arbeitet;
e) es wird bei konstantem Reaktivgasfluss von der elektrischen Leistung (P1), welche die erste Kennlinie (I) bestimmt, auf die elektrische Leistung (P2), welche die zweite Kennlinie (II) bestimmt, periodisch umgeschaltet.

15. Verfahren nach Anspruch 14, **dadurch gekennzeichnet, dass** der Arbeitspunkt (IV) der ersten Kennlinie (I) und der Arbeitspunkt (B') der zweiten Kennlinie (II) so gewählt werden, dass bei ihnen der gleiche Reaktivgasfluss herrscht.

16. Verfahren nach Anspruch 15, **dadurch gekennzeichnet, dass** die Gerade (G), die durch die beiden Arbeitspunkte (IV, B') geht, einen hinreichenden Abstand von den Hysterese-Eckpunkten (K1 bis K8) der Entladespannungs-Reaktivgaszuführungs-Kennlinien (I, II) aufweist.

## Claims

1. Sputtering device for etching or coating a substrate with metal compounds obtained by sputtering a metal target and combining the target particles generated in this way with a reactive gas, with
1.1 a process volume (2);
1.2 a reactive gas feed (15, 16) into the process volume (2);
1.3 at least one electrode (20, 21) connectable to an electrical energy supply (34) with the discharge voltage of the electrode (20, 21) being a function of the quantity of the reactive gas admitted per unit time;
1.4 a device which is arranged for periodically changing over the electrical power supplied to the electrode (20, 21) between a first and a second value;
**characterized in that** the first and the second power value (P1, P2) are selected such that at the same reactive gas inflow the target (22, 23) at the first power value (P1) is in metallic mode (A) while at the second power value (P2) it is in oxide mode (B').

2. Sputtering device as stated in claim 1, with two electrodes (20, 21), whereby the device for periodically switching from the first supplied electrical power (P1) to the second electrical power (P2) is arranged for supplying both electrodes with the same power (P1 or P2).

3. Sputtering device as stated in claim 1, with two electrodes (20, 21), whereby the device for periodically switching from the first supplied electrical power (P1) to the second electrical power (P2) is arranged for supplying the first electrode (20) with a first power (P1), and for supplying simultaneously the second one (21) with a second power (P2), and for supplying in a succeeding time interval the first electrode (20) with the second power (P2) and the second electrode (21) with the first power (P1).

4. Sputtering device as stated in claim 1, **characterized in that** the device for periodically switching from the first supplied electrical power (P1) to the second electrical power (P2) is a modulated AC voltage source (34).

5. Sputtering device as stated in claim 1, **characterized in that** the device for periodically switching from the first supplied electrical power (P1) to the second supplied electrical power (P2) comprises a DC current source and an AC current source, whereby the DC and the AC are superimposed.

6. Sputtering device as stated in claim 1, **characterized in that** the device for periodically switching from a first supplied power (P1) to the second supplied electrical power (P2) is a DC current source (60) whose outputs can be switched over by means of switches (63 to 66).

7. Sputtering device as stated in claim 5, **characterized in that** the superimposed AC voltage has a frequency between 2 to 30 Hz.

8. Sputtering device as stated in claim 1, **characterized in that** the switching from metallic mode to oxide mode and conversely takes place at a cycle frequency of 10 Hz.

9. Sputtering device as stated in claim 1, **characterized in that** the device by means of which the electrical power supplied to the electrode can be switched over between a first and a second value, comprises an AC voltage source (34) which is modulated by a further AC voltage source (42).

10. Sputtering device as stated in claim 9, **characterized in that** it comprises a network and a capacitor, whereby the AC voltage source (42) is connected via the network (41) to the output of the first AC voltage source (34), with this network (41) being connected to the capacitor (39) disposed in an output line of the AC voltage source (34).

11. Sputtering device as stated in claim 1, comprising a target (22, 23), permanent magnets (24 to 29), a housing (2) and a diaphragm (14), whereby the electrode (20, 21) together with the target (22, 23) and the permanent magnets (24 to 26; 27 to 29) forms a magnetron (3, 4), whereby this magnetron (3, 4) is disposed within the housing to be evacuated (2) and is disposed opposing the substrate (13) and whereby the housing (2) comprises the diaphragm (14) between substrate (13) and magnetron (3, 4).

12. Sputtering device as stated in claim 11, comprising a device for introducing a reactive gas mixture into the housing (2), whereby the gas mixture is introduced between the substrate (13) and the diaphragm (14).

13. Sputtering device as stated in claim 1, comprising an electrical energy source, whereby the electrical energy source comprises an intermediate frequency generator (34) with a frequency f₀ and a network with a resonance frequency f₁ with f₀ and f₁ being so closely adjacent to each other that floating results which modulates the power of the sputtering device.

14. Process for setting an operating point of a sputtering device as stated in claim 1, **characterized by** the following steps:
a) a first discharge voltage-reactive gas feed characteristic (I) at a first electrical power (P1) is determined;
b) a second discharge voltage-reactive gas feed characteristic (II) at a second electrical power (P2) is determined;
c) on the first discharge voltage-reactive gas feed characteristic (I) an operating point (IV) is determined at which the sputtering device operates in metallic mode;
d) on the second discharge voltage-reactive gas feed characteristic (II) an operating point (B') is determined at which the sputtering device operates in oxide mode;
e) at constant reactive gas flow periodically switching from the electrical power (P1) which determines the first characteristic (I) to the electrical power (P2) which determines the second characteristic (II).

15. Process as stated in claim 14, **characterized in that** the operating point (IV) of the first characteristic (I) and the operating point (B') of the second characteristic (II) are selected such that at them the same reactive gas flow is obtained.

16. Process as stated in claim 15, **characterized in that** the straight line (G) which passes through the two operating points (IV, B') is spaced adequately with respect to the hysteresis corner points (K1 to K8) of the discharge voltage-reactive gas feed characteristics (I, II).

## Revendications

1. Dispositif de pulvérisation permettant de corroder ou de revêtir un substrat avec des composés métalliques qui sont obtenus en pulvérisant une cible métallique et en combinant les particules cibles ainsi produites avec un gaz réactif, ledit dispositif comprenant
1.1 un espace de processus (2);
1.2 un conduit d'admission de gaz réactif (15, 16) menant dans l'espace de processus (2);
1.3 au moins une électrode (20, 21) qui peut être reliée à une alimentation en énergie électrique (34), la tension de décharge de l'électrode (20, 21) dépendant de la quantité de gaz réactif amenée par unité de temps;
1.4 un organe qui est réglé pour commuter de manière périodique la puissance électrique amenée à l'électrode (20, 21) entre une première et une deuxième valeur;
**caractérisé en ce que** la première et la deuxième valeur de puissance (P1, P2) sont sélectionnées de sorte que, l'admission de gaz réactif restant la même, la cible (22, 23) se trouve à la première valeur de puissance (P1) en mode métallique (A) alors qu'elle se trouve, à la deuxième valeur de puissance (P2), en mode oxydique (B').

2. Dispositif de pulvérisation selon la revendication 1 comprenant deux électrodes (20, 21), l'organe permettant la commutation périodique de la première puissance électrique amenée (P1) à la deuxième puissance électrique (P2) étant réglé pour exposer les deux électrodes à respectivement la même puissance (P1 ou P2).

3. Dispositif de pulvérisation selon la revendication 1 comprenant deux électrodes (20, 21), l'organe permettant la commutation périodique de la première puissance électrique amenée (P1) à la deuxième puissance électrique (P2) étant réglé pour exposer la première électrode (20) à une première puissance (P1) tout en exposant la deuxième (21) à une deuxième puissance (P2) et, dans un espace de temps qui suit, d'exposer la première électrode (20) à la deuxième puissance (P2) et la deuxième électrode (21) à la première puissance (P1).

4. Dispositif de pulvérisation selon la revendication 1, **caractérisé en ce que** l'organe permettant la commutation périodique de la première puissance électrique amenée (P1) à la deuxième puissance électrique (P2) est une source de tension alternative modulée (34).

5. Dispositif de pulvérisation selon la revendication 1, **caractérisé en ce que** l'organe permettant la commutation périodique de la première puissance électrique amenée (P1) à la deuxième puissance électrique amenée (P2) comprend une source de courant continu et une source de courant alternatif, le courant continu et le courant alternatif étant superposés.

6. Dispositif de pulvérisation selon la revendication 1, **caractérisé en ce que** l'organe permettant la commutation périodique d'une première puissance amenée (P1) à la deuxième puissance électrique amenée (P2) est une source de courant continu (60) dont les sorties peuvent être commutées au moyen de commutateurs (63 à 66).

7. Dispositif de pulvérisation selon la revendication 5, **caractérisé en ce que** la tension alternative superposée présente une fréquence comprise entre 2 et 30 Hz.

8. Dispositif de pulvérisation selon la revendication 1, **caractérisé en ce que** la commutation du mode métallique au mode oxydique et inversement s'effectue avec une fréquence de cycle de 10 Hz.

9. Dispositif de pulvérisation selon la revendication 1, **caractérisé en ce que** l'organe grâce auquel la puissance électrique amenée à l'électrode peut être commutée entre une première et une deuxième valeur comprend une source de tension alternative (34), laquelle est modulée par une autre source de tension alternative (42).

10. Dispositif de pulvérisation selon la revendication 9, **caractérisé en ce qu'**il comprend un réseau et un condensateur, la source de tension alternative (42) étant reliée, par le biais du réseau (41), à la sortie de la première source de tension alternative (34), ledit réseau (41) se trouvant au niveau du condensateur (39) qui est disposé dans une ligne de sortie de la source de tension alternative (34).

11. Dispositif de pulvérisation selon la revendication 1 comprenant une cible (22, 23), des aimants permanents (24 - 29), une enceinte (2) et un écran (14), l'électrode (20, 21) formant ensemble avec la cible (22, 23) et les aimants permanents (24 - 26; 27 - 29) un magnétron (3, 4), ledit magnétron (3, 4) se trouvant à l'intérieur de l'enceinte à évacuer (2) et étant disposé en regard du substrat (13), et l'enceinte (2) présentant entre le substrat (13) et le magnétron (3, 4) l'écran (14).

12. Dispositif de pulvérisation selon la revendication 11 comprenant un organe permettant d'introduire un mélange gazeux réactif dans l'enceinte (2), le mélange gazeux étant introduit entre le substrat (13) et l'écran (14).

13. Dispositif de pulvérisation selon la revendication 1 comprenant une source d'énergie électrique, la source d'énergie électrique présentant un générateur à fréquence moyenne (34) avec une fréquence f₀ et un réseau avec une fréquence de résonance f₁, f₀ et f₁ étant tellement proches l'une de l'autre qu'il en résulte un battement qui module la puissance du dispositif de pulvérisation.

14. Procédé permettant de régler un point de fonctionnement d'un dispositif de pulvérisation selon la revendication 1 **caractérisé par** les étapes suivantes:
a) une première courbe caractéristique tension de décharge/admission de gaz réactif (I) est déterminée à une première puissance électrique donnée (P1);
b) une deuxième courbe caractéristique tension de décharge/admission de gaz réactif (II) est déterminée à une deuxième puissance électrique donnée (P2);
c) sur la première courbe caractéristique tension de décharge/admission de gaz réactif (I) est déterminé un point de fonctionnement (IV) où le dispositif de pulvérisation fonctionne en mode métallique;
d) sur la deuxième courbe caractéristique tension de décharge/admission de gaz réactif (II) est déterminé un point de fonctionnement (B') où le dispositif de pulvérisation fonctionne en mode oxydique;
e) alors que le flux de gaz réactif reste constant, il est effectué une commutation périodique de la puissance électrique (P1) qui détermine la première courbe caractéristique (I) à la puissance électrique (P2) qui détermine la deuxième courbe caractéristique (II).

15. Procédé selon la revendication 14, **caractérisé en ce que** le point de fonctionnement (IV) de la première courbe caractéristique (I) et le point de fonctionnement (B') de la deuxième courbe caractéristique (II) sont sélectionnés de telle sorte que le flux de gaz réactif régnant en ces points soit le même.

16. Procédé selon la revendication 15, **caractérisé en ce que** la droite (G) qui passe par les deux points de fonctionnement (IV, B') présente une distance suffisante par rapport aux sommets d'hystérésis (K1 à K8) des courbes caractéristiques tension de décharge/admission de gaz réactif (I, II).
